# EUROPEAN PATENT APPLICATION

(11) **EP 4 585 936 A1**
(43) Date of publication of application: **16.07.2025**
(21) Application number: 24151038.7
(22) Date of filing: 09.01.2024
(51) Int. Cl.: G01R 31/28

(54) **TESTING SYSTEM FOR ELECTRONIC DEVICES**

(71) Applicant: 2Bits S.r.l., 25038 Rovato (BS) (IT)
(72) Inventor: TERENGHI, Riccardo, 25038 Rovato (BS) (IT); BONASSI, Alessandro, 25038 Rovato (BS) (IT); BRUNELLI, Riccardo, 25038 Rovato (BS) (IT)
(74) Representative: Brunacci, Marco

(57) **Abstract**

The testing system (1) of electronic devices comprises:
- backing means (2) comprising at least one electronic backing board (3) on which are mounted, in electrical connection with the same backing board, a plurality of electronic devices (4) to be tested, the backing board (3) being provided with at least one electrical link connector (5) connected to the devices (4);
- testing means (8, 21), in use, electrically connected to the link connector (5) in a removable manner;
wherein the testing means (8, 21) comprise at least one control module (8) provided with at least one electronic control board (9) provided with:
- at least one control connector (10) connectable, in a removable manner, to the link connector (5);
- at least one measuring connector (11) connected, in use, to a measuring instrument (12).

## Description

### Technical Field

The present invention relates to a testing system for electronic devices.

### Background Art

Some testing systems used to measure the operational characteristics of one or more electronic devices are well known.

Generally, this type of systems makes use of appropriate control means configured to test a device and assess the operation thereof.

These systems are used, e.g., to evaluate the operation of devices that have been subjected to critical operating conditions, such as e.g. operating temperatures and/or power supply voltages that are deemed critical or particularly stressful for the device.

In fact, it is well known that some testing systems are provided with appropriate stress means configured to subject the devices to critical operating conditions. For this purpose, the stress means are generally provided with appropriate temperature-controlled chambers and appropriate stress boards configured to regulate the power supply voltage supplied to the device.

This type of systems often makes use of a backing board on which a plurality of devices to be tested are mounted and which can be housed within the controlled-temperature chamber and connected to the stress board, so that a plurality of devices can be tested at the same time.

In this way, this type of systems allows both subjecting devices to critical conditions and controlling the operation thereof.

This type of systems is, however, susceptible to some refinements.

In fact, the control means employed by the systems of known type make use of control modules provided with an individual control slot adapted to receive one device at a time.

This drawback significantly slows down the execution time of the tests performed by means of the control means, particularly when a significant number of devices need to be tested.

In this case, in fact, an operator is required to sequentially connect the devices to be tested to the control slot, each time replacing the previously tested device. For example, in the event of the system making use of the stress means, the operator must also arrange to disassemble the device from the backing board to connect it to the control slot and finally to place it back on the backing board.

In addition, the systems of known type make use of open backing boards that expose the devices to the risk of being damaged, e.g. due to the contact of the board (or directly of a device) with foreign bodies or otherwise, altering the results from testing operations.

In addition, the stress means employed by known systems involve connecting the stress board directly to the backing board.

This, however, exposes one portion of the stress board to critical working conditions, causing the stress board to be damaged or broken over time.

In addition, the stress means require time-consuming operations to configure the power supply voltages and/or the temperatures to be provided to the devices to be stressed, greatly increasing the time required to perform testing operations. Therefore, these drawbacks make the systems of known type inconvenient and expensive to use.

### Description of the Invention

The main aim of the present invention is to devise a testing system of electronic devices which allows devices to be tested simply, easily and quickly.

An additional object of the present invention is to devise a testing system of electronic devices which allows the devices to be tested safely, thus reducing the risk of accidental damage and/or breakage of the devices.

An additional object of the present invention is to devise a testing system of electronic devices with low maintenance and/or upkeep costs.

Still one object of the present invention is to devise a testing system of electronic devices which allows the devices to be tested automatically and/or semi-automatically.

Another object of the present invention is to devise a testing system of electronic devices which allows the aforementioned drawbacks of the prior art to be overcome within the framework of a simple, rational, easy and effective to use as well as inexpensive solution.

The aforementioned objects are achieved by this system having the characteristics of claim 1.

The aforementioned objects are achieved by this process having the characteristics of claim 14.

### Brief Description of the Drawings

Other characteristics and advantages of the present invention will become more apparent from the description of a preferred, but not exclusive, embodiment of a testing system of electronic devices, illustrated by way of an indicative, yet nonlimiting example, in the accompanying tables of drawings in which:

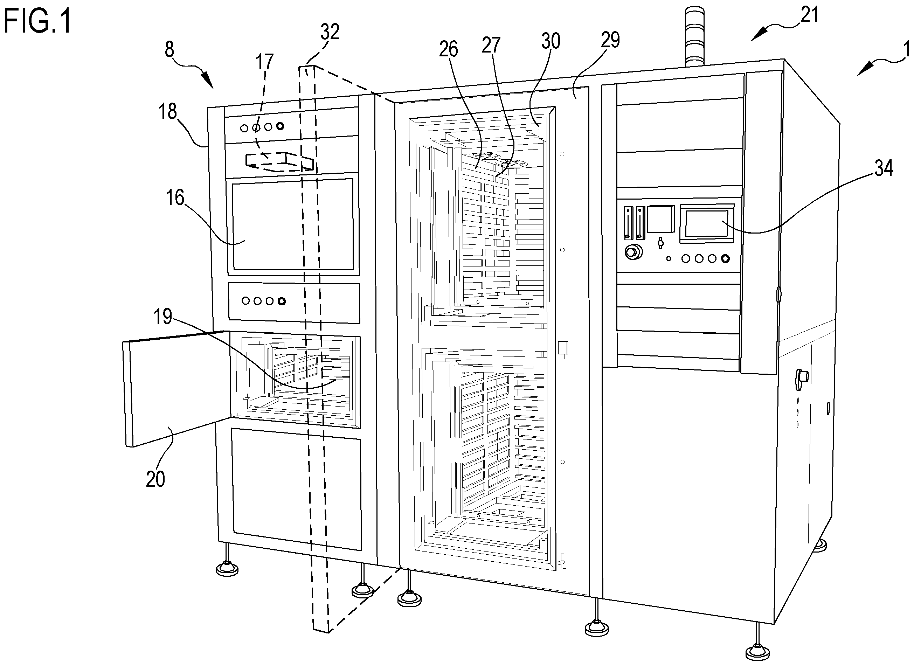

Figure 1 is an axonometric schematic view of the system according to the invention;

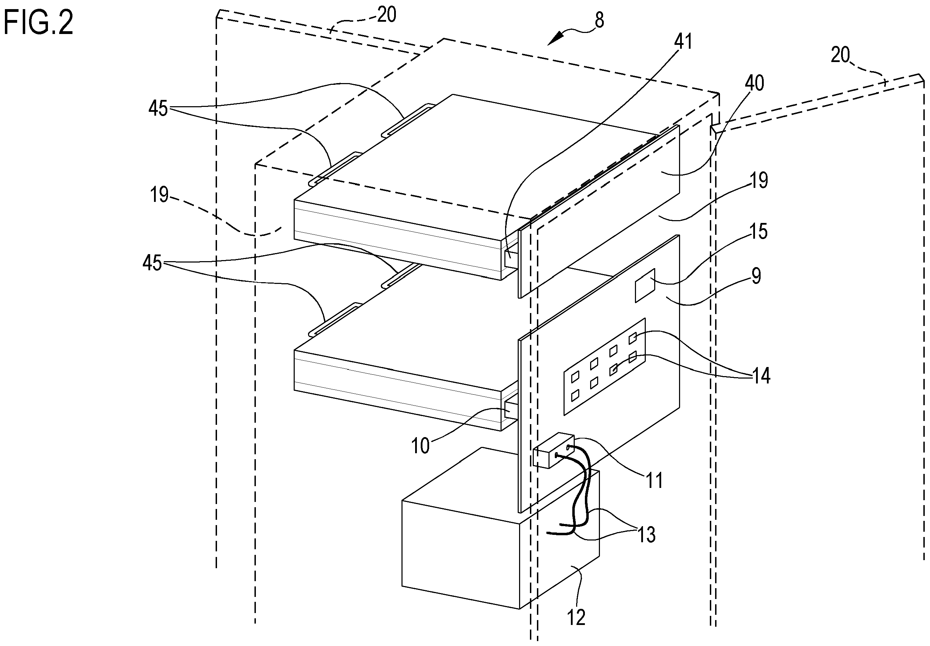

Figure 2 is a schematic detailed view of a system module according to the invention;

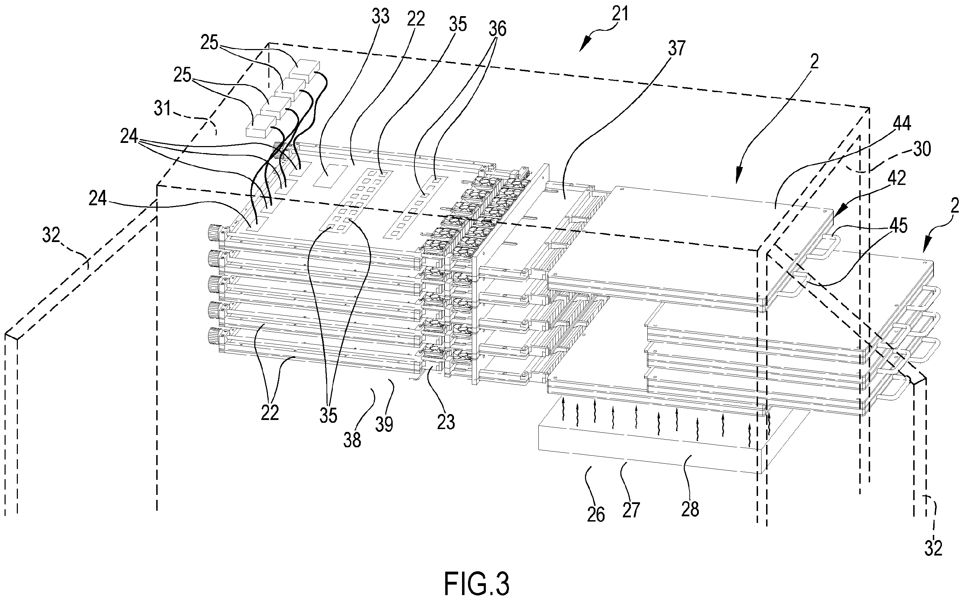

Figure 3 is a schematic detailed view of another system module according to the invention;

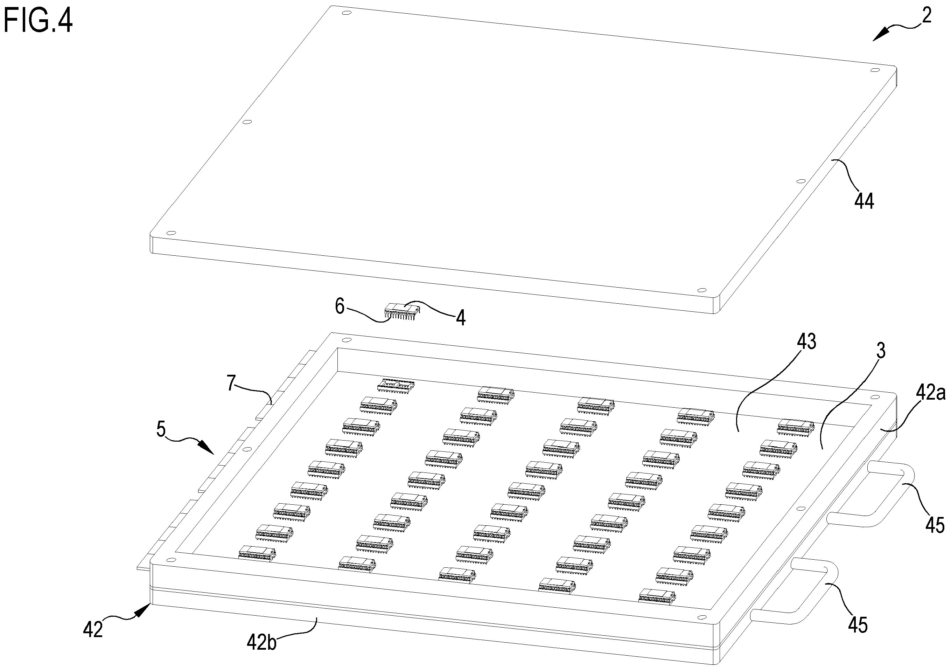

Figure 4 is a schematic detailed view of some system components according to the invention.

### Embodiments of the Invention

With particular reference to these figures, reference numeral 1 globally denotes a testing system of electronic devices.

The testing system 1 of electronic devices comprises backing means 2 provided with at least one electronic backing board 3 on which are mounted, in electrical connection to the same backing board 3, a plurality of electronic devices 4 to be tested.

Preferably, the devices 4 are all the same.

In other words, the devices 4 are all of the same type.

Conveniently, each device 4 is coupled to the backing board 3 in a removable manner.

It cannot be ruled out that the system 1 may comprise the devices 4.

Preferably, the devices 4 are of the Metal Oxide Semiconductor (MOS) type or the like.

Preferably, the devices are of the MOS type without Electrostatic Discharges (ESD) protection.

According to the invention, the backing board 3 is provided with at least one electrical link connector 5 connected to the devices 4 to receive one or more output signals from one or more of the devices 4 and/or to transmit one or more input signals to one or more of the devices 4.

Appropriately, the backing board 3 comprises a plurality of conductive tracks, not shown in the figures, which connect the devices 4 to the link connector 5.

In addition, each device 4 comprises a plurality of contacts 6 connected, in use, to respective conductive tracks.

Advantageously, the link connector 5 comprises a plurality of connection pins 7 connected to the contacts 6 by means of conductive tracks.

In this way, the devices 4 mounted on the backing board 3 receive the input signals and/or transmit the output signals by means of the link connector 5. Preferably, the backing board 3 is of the type of a PCB or the like.

According to the invention, the system 1 comprises testing means 8, 21, in use, electrically connected to the link connector 5 in a removable manner to transmit to the same one or more of the input signals and/or to receive from the same one or more of the output signals.

In addition, the testing means 8, 21 comprise at least one control module 8 provided with at least one electronic control board 9.

According to the invention, the control board 9 is provided with:
- at least one control connector 10 connectable, in a removable manner, to the link connector 5 to receive from the latter one or more of the output signals and/or to transmit to the latter one or more of the input signals;
- at least one measuring connector 11 connected, in use, to a measuring instrument 12 configured to generate one or more of the measuring input signals and/or to receive and to measure one or more of the output signals, so as to test one or more of the devices 4.

Preferably, the term "measuring input signal" means a type of input signal generated by the measuring instrument 12 and to be transmitted to one or more of the devices 4.

For example, one or more of the measuring input signals generated by the measuring instrument 12 are power supply signals of a device 4 which, in response, is preferably configured to generate one or more of the output signals detected and/or measured by the same measuring instrument 12 to test the device 4.

Advantageously, the link connector 5 allows the control board 9 to be connected to the backing board 3. In this way, the control board 9 takes action on the devices 4 by interposition of the backing board itself, without the need, e.g., to disassemble the devices 4 from the backing board 3 as is the case with the testing means of known type.

Advantageously, the control board 9 comprises a plurality of conductive tracks, not shown in the figures, configured to connect the control connector 10 to the measuring connector 11, so that one or more of the input signals and/or one or more of the output signals can be exchanged between the measuring connector 11 (and thus the measuring instrument 12) and the control connector 10 (and thus one or more of the devices 4).

Preferably, the control board 9 is a PCB or the like.

It cannot be ruled out that the system 1 may comprise the measuring instrument 12.

Preferably, the measuring instrument 12 is a Source Measure Unit (SMU). Advantageously, the measuring connector 11 is connected, in use, to the measuring instrument 12 by means of one or more connecting cables 13, e.g., of the type of shielded triaxial cables.

It cannot be ruled out that the control board 9 may comprise a plurality of measuring connectors 11 which can be connected to the same measuring instrument 12 and/or which can be connected to different measuring instruments. According to a possible, but not exclusive, embodiment of the system 1, the control board 9 comprises at least seven measuring connectors 11, each connected to the measuring instrument 12 by means of a corresponding connecting cable 13, where, e.g., four connecting cables 13 are devoted to the power supply of corresponding contacts 6 of a device 4, other two connecting cables 13 are devoted to the measurement of corresponding contacts 6 of the device 4 (preferably two of the contacts 6 powered by the connecting cables 13 devoted to the power supply), and an additional connecting cable 13 is devoted to the grounding of another contact 6 of the device 4.

Conveniently, the control board 9 comprises one or more electrically connected switch components 14 positioned between the measuring connector 11 and the control connector 10 and switchable to connect and disconnect the measuring connector 11 to one or more of the devices 4 to transmit to the same one or more of the measuring input signals and/or to receive from the same one or more of the output signals, respectively.

Preferably, the switch component 14 is of the type of a relay or the like. Advantageously, the control board 9 comprises:
- a plurality of switch components 14;
- at least one control unit 15 operationally connected to the switch components 14 and configured to command the latter in a plurality of measuring configurations in each of which the measuring connector 11 is connected to a different device 4 and is disconnected from the remaining devices 4.

In other words, in each measuring configuration, one or more of the measuring connectors 11 are connected only to one device 4, while they are disconnected from the remaining devices 4.

This expedient allows the system 1 to control one or more of the devices 4 directly on the backing board 3, by connecting the latter to the control board 9.

In this way, the devices 4 do not have to be disassembled from the backing board 3 as is the case for the testing systems of known type.

Preferably, the control board 9 comprises a group of switch components 14 for each device 4.

Specifically, each group of switch components 14 is connected to the contacts 6 of a corresponding device 4.

In this way, the control unit 15 is configured to command the group of switch components 14 to transmit to one more contacts 6 one or more measuring input signals and/or to receive from one or more contacts 6 one or more output signals. In other words, in each measuring configuration, the control unit 15 is configured to control which and/or how many contacts 6 of the corresponding device 4 are connected and/or disconnected to one or more of the measuring connectors 11.

Specifically, in different measuring configurations, although the devices 4 connected to one or more of the connectors 11 are different in each configuration, the contacts 6 of the devices 4 are connected in the same way to one or more of the measuring connectors 11.

Conveniently, the control unit 15 is configured to command the switch components 14 so as to vary between different measuring configurations, that is, to vary the device 4 connected to one or more of the measuring connectors 11.

Specifically, the control unit 15 is configured to vary, in a sequential manner, among different measuring configurations, so that a predefined number of different devices 4, preferably all of them, can be sequentially connected to one or more of the measuring connectors 11.

It cannot, however, be ruled out that the backing board 3 may comprise additional switch components configured to operate in conjunction with the switch components 14 of the control board 9 to accomplish what has been described above with reference to the switch components 14, e.g. in combination with the control unit 15.

Conveniently, the control module 8 comprises a command unit 16, such as e.g. a PC or the like, configured to manage at least one of either the control unit 15 or the measuring instrument 12.

Specifically, the system 1 comprises command software run by the command unit 16 and preferably used by an operator to manage at least one of either the control unit 15 or the measuring instrument 12.

Preferably, through the command software, the command unit 16 is configured to set which devices 4 to connect in succession in the different measuring configurations.

It cannot also be ruled out that the command unit 16, through the command software, may be configured to set which contacts 6 of the device 4 to connect to which measuring connectors 11.

Preferably, through the command software, the command unit 16 is configured to set the type and value of one or more of the measuring input signals.

Conveniently, the command unit 16 is configured to process one or more of the output signals.

Specifically, the command unit 16 is configured to perform one or more mathematical computations to process one or more of the output signals and to generate, e.g., one or more parameters of interest.

Preferably, such mathematical operations and/or such parameters are set through the command software.

Conveniently, the control module 8 comprises at least one data storage unit 17 configured to digitally store one or more pieces of information managed by the command unit 16, e.g. input signals, output signals, mathematical operations, parameters or other.

Conveniently, the control module 8 comprises at least one control frame 18 configured to receive, in use, the backing means 2 and the control board 9.

Specifically, the control frame 18 comprises at least one housing compartment 19 of at least one of either the backing means 2 or the backing board 3.

Preferably, the control frame 18 comprises a pair of housing compartments 19, wherein one housing compartment 19 is intended to house the backing means 2 and the other housing compartment 19 is intended to house the control board 9. Conveniently, the control frame 18 comprises at least one door 20 adapted to allow and prevent the access to at least one housing compartment 19.

Preferably, the control frame 18 comprises a door 20 for each housing compartment 19.

Appropriately, the housing compartments 19 are mounted on opposite sides of the control frame 18.

In particular, the control board 9 and the backing board 3 are electrically connected to each other, preferably directly, when received from the control frame 18.

Conveniently, the testing means 8, 21 comprise at least one stress module 21 provided with at least one stress board 22 provided with at least one stress connector 23 connectable, in a removable manner, to the link connector 5 to receive from the latter one or more of the output signals and/or to transmit to the latter one or more of the input signals and at least one power connector 24 connected, in use, to a power source 25 configured to generate one or more of the power input signals, so as to test one or more of the devices 4.

Preferably, the term "power input signal" means a type of input signal generated by the power source 25 and to be transmitted to one or more of the devices 4.

For example, one or more of the power input signals generated by the power source 25 are power signals of a device 4 to test the reliability thereof, e.g. in combination with the application of a thermal stress.

Appropriately, the stress board 22 comprises a plurality of conductive tracks connecting the stress connector 23 to the power connector 24.

Preferably, the stress board 22 is of the type of a PCB or the like. Advantageously, the power connector 24 is connected to the same contact 6 of different devices 4.

In other words, the same contact 6 of a plurality of devices 4, preferably all of them, is connected to the power connector 24.

In this way, the same contacts 6 of different devices 4 are powered all in the same way.

It cannot, however, be ruled out that the power connector 24 may be connected to a plurality of contacts 6 of the devices 4.

It cannot be ruled out that the system 1 may comprise the power source 25.

Conveniently, the power source 25 is configured to generate one or more of the power input signals having a voltage value which can be set in an arbitrary manner, e.g. by a user.

Preferably, this value is settable up to a predetermined maximum voltage value, e.g. 200 V.

Conveniently, the stress module 21 comprises at least one stress portion 26 defining a stress area 27 adapted, in use, to receive, the backing board 3 to be tested.

In addition, the stress module 21 comprises heating means 28 adapted, in use, to heat the backing board 3 where the stress area 27 is located, thus subjecting the backing board 3 to thermal stress, so as to test one or more of the devices 4. Appropriately, the stress module 21 comprises at least one stress frame 29 comprising a controlled-temperature stress chamber 30 within which the stress portion 26 is arranged.

In other words, the stress chamber 30 is intended to receive the backing means 2. In addition, the heating means 28 are configured, in use, to heat the environment within the stress chamber 30 so as to thermally stress the backing board 3. Advantageously, the stress module 21 comprises a safe portion 38 defining a safe area 39 adapted, in use, to receive the stress board 22.

In addition, the safe area 39 has a lower temperature than that of the stress area 27 to preserve the integrity of the stress board 22.

Preferably, the safe area is at room temperature.

Conveniently, the stress frame 29 comprises a housing chamber 31, preferably arranged opposite the stress chamber 30 and within which the safe portion 38 is arranged.

In other words, the housing chamber 31 is intended to receive the stress board 22. Conveniently, at least one of either the stress chamber 30 or the housing chamber 31 comprises a closure body 32 adapted to close and open the corresponding chamber 30, 31.

Preferably, each chamber 30, 31 comprises a corresponding closure body 32. Advantageously, the system 1 is movable between a stress configuration, wherein the backing board 3 is connected to the stress board 22, and a control configuration, wherein the backing board 3 is connected to the control board 9. In this way, the system 1 is configured to stress the devices 4 and to control the same devices, leaving them mounted on the backing board 3.

Preferably, the stress module 21 is manually movable between the stress configuration and the control configuration.

Conveniently, the stress board 22 comprises a verification unit 33 configured to detect and/or measure one or more of the power input signals received from the power connector 24.

Specifically, the verification unit 33 is configured to detect and/or measure the current and/or voltage of one or more of the power input signals received from the power connector 24, that is, generated by the power source 25.

More specifically, the verification unit 33 is configured to detect and/or measure the current and/or voltage values comprised between a plurality of ranges.

For example, the verification unit 33 is configured to detect and/or measure the current values of between:
- 1 mA and 10 mA; and/or
- 100 µA and 1mA; and/or
- 10 µA and 100 µA: and/or
- 1 µA and 10 µA.

Conveniently, the verification unit 33 is configured to generate at least one alarm signal depending on the detection and/or measurement of one or more of the power input signals.

For example, the verification unit 33 is configured to compare one or more of the power input signals received from the power connector 24 with one or more reference values, so as to issue the alarm signal depending on the result of this comparison.

Conveniently, the stress module 21 comprises a management unit 34, such as e.g. a PC or the like, configured to manage at least one of either the verification unit 33 or the power source 25.

Specifically, the system 1 comprises management software run from the management unit 34 and preferably used by an operator to manage at least one of either the verification unit 33 or the power source 25.

Preferably, through the management software, the management unit 34 is configured to set the current range to be detected and/or measured by means of the verification unit 33.

Preferably, through the software, the management unit 34 is configured to set the voltage value of one or more of the power input signals generated by the power source 25.

It cannot, however, be ruled out that the management unit 34 may be configured to manage the heating means 28. For example, it cannot be ruled out that, through the management software, the management unit 34 may be configured to set the temperature of the stress area 27.

Advantageously, the stress board 22 comprises a plurality of electrically connected switch elements 35 positioned between the power connector 24 and the stress connector 23 and switchable to connect and disconnect the power connector 24 to one or more of the devices 4 to allow and prevent the power supply thereof with one or more of the power input signals, respectively.

Specifically, one or more of the switch elements 35 are movable between:
- at least a first state, wherein they connect the power connector 24 to at least one of the devices 4 to allow them to be powered by one or more of the power input signals;
- at least a second state, wherein they disconnect the power connector 24 from one or more of the devices 4 to prevent them from being powered by one or more of the power input signals, and wherein they connect one or more of the same devices to the ground.

In this way, the contact 6 is grounded whenever it is disconnected from the power connector 24.

Advantageously, the verification unit 33 is operationally connected to the switch elements 35 and is configured to command at least one of the switch elements 35 depending on the detection and/or measurement of one or more of the power input signals received from the power connector 24.

Conveniently, the stress board 22 comprises at least one disconnection element 36 for each device 4.

In addition, each disconnection element 36 is configured to connect and disconnect a corresponding device 4 from the power connector 24.

Specifically, each disconnection element 36 is configured to connect and disconnect at least one contact 6 of a corresponding device 4 from the power connector 24.

It cannot be ruled out that the stress board 22 may comprise a plurality of disconnection elements 36 for each device 4, wherein each disconnection element 36 is configured to connect and disconnect a corresponding contact 6 from the power connector 24.

Preferably, the disconnection element 36 is of the type of an electronic jumper or the like.

This expedient makes it possible to disconnect one or more devices 4 from the power connector 24, e.g., so that these devices suffer only the thermal stress induced by the heating means 28.

Conveniently, the stress board 22 comprises a plurality of power connectors 24. In particular, the same contact 6 of different devices 4 is connected in the same way to one or more power connectors 24.

It cannot, however, be ruled out that the different contacts 6 of the same device 4 may be connected to one or more different power connectors 24 than the other contacts 6 of the same device.

In this way, a plurality of devices 4, preferably all of them, are connected in the same way to the power connectors 24.

In other words, a plurality of devices 4, preferably all of them, are powered in the same way from the power sources 25.

Conveniently, each of the power connectors 24 is connectable to one or more of the devices 4 by interposition of one or more switch elements 35.

Conveniently, the stress module 21 comprises at least one interface board 37 adapted to electrically connect the backing board 3 and the stress board 22 to each other.

In addition, the interface board 37 is connected, in use, positioned between the link connector 5 and the stress connector 23 in a removable manner.

Specifically, the stress connector 23 is connected to the link connector 5 in a removable manner by interposition of the interface board 37 so as to distance the stress board 22 from the stress area 27 to preserve the integrity of the same stress board.

Appropriately, the interface board 37, in use, is positioned between the stress area 27 and the safe area 39.

Advantageously, the system 1 comprises a plurality of backing means 2 and a plurality of stress boards 22.

In addition, the stress module 21 comprises:
- a plurality of stress portions 26, each adapted to receive corresponding backing means 2; and/or
- a plurality of safe portions 38, each adapted to receive a corresponding stress board 22; and/or
- a plurality of interface boards 37, each connected, in use, between a corresponding backing board 3 and a corresponding stress board 22.

Advantageously, the system 1 comprises at least one discharge board 40 having a discharge connector 41 connectable to the link connector 5 in a removable manner.

Appropriately, the discharge board 40 comprises a plurality of conductive tracks connected to the discharge connector 41.

Preferably, the discharge board 40 is of the type of a PCB or the like.

Advantageously, the discharge board 40 is configured to connect one or more devices 4, preferably all of them, to the same electrical potential.

More specifically, the discharge board 40 is configured to connect all the contacts 6 of the devices 4 to the same electrical potential.

In this way, one or more devices 4 can be connected and/or disconnected, preferably in the manual mode, in a safe manner to/from the backing board 3, preventing the occurrence of potentially harmful phenomena to the devices 4 such as e.g. ESD (Electrostatic discharge).

Conveniently, the system 1 is movable between a discharge configuration, wherein the backing board 3 is connected to the discharge board 40, and at least one of either the control configuration or the stress configuration.

Preferably, the stress module 21 is manually movable between the discharge configuration and at least one of either the stress configuration or the control configuration.

Preferably, the control module 8 comprises the discharge board 40.

Specifically, the discharge board 40 is mounted on the control frame 18.

It cannot, however, be ruled out that the testing means 8, 21 may comprise a discharge module, separate from the control module 8 and/or from the stress module 21 and provided with the discharge board 40 and possibly with its own supporting frame.

Conveniently, the backing means 2 comprise at least one containment body 42 within which the backing board 3 is housed, in use.

Preferably, the containment body 42 is made, at least partly, of electrically conductive material so as to substantially make electromagnetic shielding for the backing board 3 and for the devices 4.

This expedient is particularly useful when using devices of the MOS type without ESD protection and therefore particularly sensitive to the electromagnetic phenomena.

Preferably, the backing board 3 comprises a portion made of electrically insulated material on which one or more of the electrically conductive components described above with reference to the backing means 2 are mounted/made.

Advantageously, the containment body 42 holds the backing board 3 within it, e.g., by retaining it, at least partly, where the portion made of an electrically insulating material is located.

Conveniently, the containment body 42 defines an access span 43 through which the backing board 3 and the devices 4 are exposed to view.

Conveniently, the backing means 2 comprise at least one cover 44 preferably made of an electrically conductive material and coupleable to the containment body 42 in a removable manner to close and open the access span 43.

Specifically, the cover 44, by plugging the access span 43, defines together with the containment body 42 an enclosure which substantially encloses the backing board 3 and the devices 4 within it in a complete manner.

Appropriately, the link connector 5 remains accessible through the containment body 42.

It cannot be ruled out that the link connector 5 may protrude, in use, outside the containment body 42, so as to be coupled to at least one of the control board 9, the stress board 22 or the discharge board 40.

Advantageously, the backing means 2 comprise at least one gripping body 45 associated with at least one of either the containment body 42 or the cover 44 and adapted to be grasped by an operator to manually move the containment body 42. Preferably, the containment body 42 comprises two the containment portions 42a, 42b which abut, in use, on opposite faces of the backing board 3 by retaining it between the portions themselves.

Appropriately, one of the containment portions 42a is open at the top to define the access span 43, while the other is preferably closed at the bottom, as shown in the figures.

Conveniently, the cover 44 is coupleable to the containment portion 42a in a removable manner to close and open the access span 43, as shown in the figures. Preferably, the control module 8 and the stress module 21 are two separate and distinct modules.

It cannot, however, be ruled out that the control module 8 and the stress module 21 may be joined to define an individual testing module.

According to a further aspect, the present invention relates to a testing process of electronic devices comprising at least the stages of:
- supplying at least one system 1;
- testing one or more of the devices 4, the testing stage comprising at least the steps of:
   - stressing one or more of the devices 4, the stress step being performed by means of the stress module 21;
   - controlling one or more of the devices 4, the control step being performed by means of the control module 8 after and/or before the stress step.

Advantageously, the testing stage involves performing the stress step before the control step.

It cannot, however, be ruled out that the testing stage comprises an additional control step carried out, preferably on previously unstressed devices 4, prior to the stress step.

In this way, the process allows checking the state of the devices 4 before and after the stress step.

It has in practice been ascertained that the described invention achieves the intended objects.

In particular, the fact is emphasized that connecting the control board directly to the backing board allows the devices to be tested easily, smoothly and quickly without disassembling the devices from the backing board.

In addition, the containment body allows the devices to be tested safely, thus reducing the risk of accidental damage and/or breakage.

In addition, the interface board allows the cost of maintaining and/or servicing the system to be reduced.

Again, the management unit and/or the command unit allow the devices to be tested automatically and/or semi-automatically, thus reducing the time required to perform testing procedures.

## Claims

1. Testing system (1) of electronic devices, comprising:
- backing means (2) comprising at least one electronic backing board (3) on which are mounted, in electrical connection with the same backing board, a plurality of electronic devices (4) to be tested, said backing board (3) being provided with at least one electrical link connector (5) connected to the devices (4) to receive one or more output signals from one or more of the devices and/or to transmit one or more input signals to one or more of the devices (4);
- testing means (8, 21), in use, electrically connected to said link connector (5) in a removable manner to transmit to the same one or more of said input signals and/or to receive from the same one or more of said output signals;
**characterized by** the fact that said testing means (8, 21) comprise at least one control module (8) provided with at least one electronic control board (9) provided with:
- at least one control connector (10) connectable, in a removable manner, to said link connector (5) to receive from the latter one or more of said output signals and/or to transmit to the latter one or more of said input signals;
- at least one measuring connector (11) connected, in use, to a measuring instrument (12) configured to generate one or more of said input signals and/or to receive and measure one or more of said output signals, so as to test one or more of the devices (4).

2. System (1) according to claim 1, **characterized by** the fact that said control board (9) comprises one or more electrically connected switch components (14) positioned between said measuring connector (11) and said control connector (10) and switchable to connect and disconnect said measuring connector (11) to one or more of the devices (4) to transmit to the same one or more of said measuring input signals and/or to receive from the same one or more of said output signals, respectively.

3. System (1) according to one or more of the preceding claims, **characterized by** the fact that said control board (9) comprises:
- a plurality of said switch components (14);
- at least one control unit (15) operationally connected to said switch components (14) and configured to command the latter in a plurality of measuring configurations in each of which said measuring connector (11) is connected to a different device (4) and is disconnected from the remaining devices (4).

4. System (1) according to one or more of the preceding claims, **characterized by** the fact that said control unit (15) is configured to vary, in a sequential manner, among different measuring configurations, so that a predefined number of different devices (4) are sequentially connected to said measuring connector (11).

5. System (1) according to one or more of the preceding claims, **characterized by** the fact that said testing means (8, 21) comprise at least one stress module (21), provided with:
- at least one stress board (22) provided with at least one stress connector (23) connectable, in a removable manner, to said link connector (5) to receive from the latter one or more of said output signals and/or to transmit to the latter one or more of said input signals, and with at least one power connector (24) connected, in use, to a power source (25) configured to generate one or more of said power input signals, so as to test one or more of the devices (4); and/or
- at least one stress portion (26) defining a stress area (27) adapted, in use, to receive, said at least one backing board (3) to be tested and heating means (28) adapted, in use, to heat said backing board (3) where said stress area (27) is located, subjecting said backing board (3) to thermal stress, so as to test one or more of the devices (4).

6. System (1) according to one or more of the preceding claims, **characterized by** the fact that it is movable between a stress configuration, wherein said backing board (3) is connected to said stress board (22), and a control configuration, wherein said backing board (3) is connected to said control board (9).

7. System (1) according to one or more of the preceding claims, **characterized by** the fact that said stress board (22) comprises a verification unit (33) configured to detect and/or measure one or more of said power input signals received from said at least one power connector (24).

8. System (1) according to one or more of the preceding claims, **characterized by** the fact that said stress board (22) comprises a plurality of electrically connected switch elements (35) positioned between said power connector (24) and said stress connector (23) and switchable to connect and disconnect said power connector (24) to one or more of the devices (4) to allow and prevent the power supply thereof with one or more of said power input signals, respectively.

9. System (1) according to one or more of the preceding claims, **characterized by** the fact that said verification unit (33) is operationally connected to said switch elements (35) and is configured to command the latter depending on the detection and/or measurement of one or more of the power input signals received from said power connector (24).

10. System (1) according to one or more of the preceding claims, **characterized by** the fact that said stress module (21) comprises at least one interface board (37) adapted to electrically connect said backing board (3) and said stress board (22) to each other, said interface board (37) being connected, in use, positioned between said link connector (5) and said stress connector (23) in a removable manner.

11. System (1) according to one or more of the preceding claims, **characterized by** the fact that it comprises at least one discharge board (40) having a discharge connector (41) which can be connected to said link connector (5) in a removable manner, said discharge board (40) being configured to connect one or more devices (4) to the same electrical potential.

12. System (1) according to one or more of the preceding claims, **characterized by** the fact that it is movable between a discharge configuration, wherein said backing board (3) is connected to said discharge board (40), and at least one of either said control configuration or said stress configuration.

13. System (1) according to one or more of the preceding claims, **characterized by** the fact that said backing means (2) comprise at least one containment body (42) within which said backing board (3) is housed, in use.

14. Testing process of electronic devices comprising at least the stages of:
- supplying at least one system (1) according to one or more of the preceding claims;
- testing one or more of the devices (4), said testing stage comprising at least the steps of:
- stressing one or more of the devices (4), said stress step being performed by means of said stress module (21);
- controlling one or more of the devices (4), said control step being performed by means of said control module (8) after and/or before said stress step.
